# EUROPÄISCHE PATENTSCHRIFT

(11) **EP 2 406 476 B1**
(45) Veröffentlichungstag und Bekanntmachung des Hinweises auf die Patenterteilung: **26.12.2012**
(21) Anmeldenummer: 10712719.3
(22) Anmeldetag: 03.03.2010
(51) Int. Cl.: F02B 77/02, C23C 14/06, C23C 30/00, C23C 14/08, C23C 14/16

(54) **VERBRENNUNGSKRAFTMASCHINE MIT EINER BRENNRAUM- ODER BRENNRAUMNAHEN OBERFLÄCHENBESCHICHTUNG SOWIE VERFAHREN ZUR BESCHICHTUNG**
INTERNAL COMBUSTION ENGINE HAVING A COMBUSTION CHAMBER SURFACE COATING OR SURFACE COATING WHICH IS CLOSE TO THE COMBUSTION CHAMBER AND METHOD FOR PRODUCING THE COATING
MOTEUR À COMBUSTION INTERNE À REVÊTEMENT DE SURFACE SITUÉ AU NIVEAU OU À PROXIMITÉ DE LA CHAMBRE DE COMBUSTION ET PROCÉDÉ POUR PRODUIRE LE REVÊTEMENT

(30) Priorität: 11.03.2009 DE 102009001500; 03.04.2009 DE 102009002183
(43) Veröffentlichungstag der Anmeldung: 18.01.2012
(73) Patentinhaber: J. Eberspächer GmbH & Co. KG, 73730 Esslingen (DE); Fraunhofer-Gesellschaft zur Förderung der angewandten Forschung e.V., 80686 München (DE)
(72) Erfinder: BACHMANN, Mischa, 38448 Wolfsburg (DE); CALVO ZUECO, Silvia, 73733 Esslingen am Neckar (DE); LANGENFELD, Stefan, 38547 Calberlah (DE); SEEMANN, Torben, 28213 Bremen (DE); ZÖLLMER, Volker, 28213 Bremen (DE); JUNG, Thomas, 38173 Sickte (DE)
(74) Vertreter: Reinstädler, Diane
(86) Internationale Anmeldenummer: PCT/EP2010/052671
(87) Internationale Veröffentlichungsnummer: WO 2010/102930

(56) Entgegenhaltungen:
- WO-A1-98/49365
- WO-A1-03/002859
- WO-A1-2007/006784
- WO-A2-97/40266
- DE-A1- 10 148 129

## Beschreibung

Die Erfindung betrifft eine zumindest einen Brennraum aufweisende Verbrennungskraftmaschine, bei der eine mit einem zu verbrennenden Luft-Kraftstoff-Gemisch oder einem Abgasstrom in Kontakt kommende Oberfläche zumindest eines Bauteils des Brennraums und/oder eines brennraumnahen, abgasströmungsführenden Bauteils der Verbrennungskraftmaschine zumindest bereichsweise eine katalytische Beschichtung aufweist. Die Erfindung betrifft ferner PVD-Verfahren zur Herstellung einer solchen Beschichtung.

Im Stand der Technik ist die Aufbringung von Beschichtungen verschiedener Bauteile im Brennraum von Brennkraftmaschinen mit einer Vielzahl von Beschichtungsmaterialien mit unterschiedlichen Eigenschaften bekannt.

So beschreibt DE 101 30 673 A (EP 1 404 955 B) eine katalytische Beschichtung von Oberflächen des Brennraums von Brennkraftmaschinen, die zwei oxidische Komponenten umfasst, nämlich ein ternäres Vanadiumoxid (insbesondere V₂O_{5-X}N_{X} oder V₂O_{5-X}C_{X}) als "Basiskatalysator" sowie ein weiteres Metalloxid, das ausgewählt ist aus Oxiden von Cer, Lanthan, Seltenerden und Übergangsmetallen. Die katalytische Beschichtung soll die Oxidation von Verkokungsrückständen des Verbrennungsprozesses unterstützen. Sie kann mit verschiedenen Verfahren erzeugt werden, wie Plasma- und Ionen-gestützten Vakuumverfahren, insbesondere Lichtbogenverdampfung; chemische Imprägnierung durch Aufbringen einer Metallsalzlösung auf die Basiskatalysatorschicht und anschließende Oxidation oder durch ein Sol-Gel-Verfahren. Einzelheiten zur Durchführung der einzelnen Verfahren werden nicht offenbart.

Aus DE 101 08 834 A sind Beschichtungen für Kolbenböden bekannt, die Ablagerungen von Kraftstoff vermindern und damit auch die Gemischbildung im Brennraum verbessern sollen. Zu diesem Zweck ist die Beschichtung als chemisch inerte und damit reaktionsunfreudige Beschichtung, als zerklüftungsarme und/oder antiadhäsive Beschichtung oder als Beschichtung mit niedrigem Reibungskoeffizienten ausgebildet. Als Materialien kommen TiN, TiAlN, ZrO₂, Cr-CN, TiZr-CNOH, TiAl-CNOH, AION, SiCH oder Ni zum Einsatz. Als Beschichtungsverfahren werden allgemein PVD-Verfahren (physical vapour deposition) genannt. Die Beschichtungen zielen ausschließlich auf eine Modifikation der physikalischen Eigenschaft der Kolbenoberfläche ab und haben keine chemisch katalytische Funktion.

DE 101 17 513 A (WO 02/081874 A) beschreibt Beschichtungen an der Kehlung und/oder dem Ventilboden von Einlassventilen, insbesondere von direkteinspritzenden Ottomotoren, welche die Verkokung des Einlassventils verhindern oder abbauen sollen. Es werden wärmeisolierende Beschichtungen aus ZrO₂, mikroporöse und/oder antiadhäsive Beschichtungen aus Cr-CN, chemisch inerte Beschichtungen aus TiZr-CHNO oder TiAl-CHNO und auch katalytische Beschichtungen aus Vanadiumnitrid (VN) oder Platin offenbart.

Hultqvist et al. (A. Hultqvist, M. Christensen & B Johanson "The Application of Ceramic and Catalytic Coatings to Reduce the Unburned Hydrocarbon Emissions from a Homogeneous Charge Compression Ignition Engine, SAE Technical Series 2000-01-1833 (2000), 1-11) haben die Auswirkungen von thermischen Barriereschichten (Al₂O₃) und katalytischen Beschichtungen (Pt-dotiertes ZrO₂) unterschiedlicher Schichtdicken im Brennraum eines im HCCl-Verfahren betriebenen Motors auf die Emissionen untersucht. Während alle Beschichtungen zu einer Verringerung der CO-Emissionen führten, hatten die katalytischen ZrO₂/Pt-Beschichtungen überraschender Weise einen negativen Effekt auf die HC-Emissionen. Insgesamt zeigten relativ dünne thermische Al₂O₃-Barriereschichten die besten Emissionsergebnisse. Die Beschichtungen wurden im Plasma-Verfahren, also einem Verfahren der Gruppe der chemischen Gasphasenabscheidungen (CVD-Verfahren für: chemical vapour deposition), aufgebracht.

DE 101 48 129 A beschreibt katalytische Beschichtungen von Brennraumoberflächen von Dieselmotoren, welche die Aktivierungsenergie für die Kraftstoffentzündung und/oder -verbrennung erniedrigen sollen, um bereits bei niedrigen Temperaturen und/oder Drücken eine zuverlässige Selbstzündung zu bewirken. Die Beschichtungen enthalten eine Trägerschicht aus SiO₂ oder rußförmigem Kohlenstoff, auf der eine katalytische Komponente aufgebracht ist, bei der es sich um Metalle der Nebengruppen, Lanthanoiden oder Actinoiden handelt, und/oder deren Oxide und Legierungen. Die katalytische Komponente liegt vorzugsweise in Form von Partikeln, insbesondere Nanopartikeln vor. Die Beschichtung kann mit physikalischer oder chemischer Gasphasenabscheidung (PVD- bzw. CVD-Verfahren) aufgebracht sein oder durch nasschemisches Imprägnieren und anschließendem thermischen Einbrennen.

EP 1 878 879 A offenbart einen Abgasturbolader, dessen strömungsführender Verdichterteil mit einer katalytischen Beschichtung versehen ist, welche ölhaltige Verunreinigungen aus so genannten Blow-By-Gasen zersetzen soll und somit deren Festsetzung und Verkokung entgegenwirken soll. Die durch thermisches Spritzen erzeugt katalytische Beschichtung umfasst zumindest ein Übergangsmetalloxid oder deren Mischungen, wobei insbesondere Oxide der Legierungen TiZrNi, AlFeCrCo und/oder AlFeCuCr zum Einsatz kommen, und optional eine Komponente wie Aluminiumoxid.

DE 10 2005 033 118 B4 beschreibt eine Brennkraftmaschine mit einem Aluminiumzylinder und/oder -kolben, deren brennraumzugewandte Seite durch Eloxieren in Aluminiumoxid mit hexagonaler Gitterstruktur überführt ist. Das hexagonale Gitter bildet ein Röhrensystem aus, das katalytische, vor dem Eloxieren zugegebene Edelmetall-Nanopartikel einschließt. Die Katalysatorpartikel haben abgaskatalytische Funktion, d.h. sie dienen der Umsetzung von Abgasschadstoffen.

Aus DE 102 19 643 A ist ein Verfahren zur Beschichtung von Katalysatorsubstraten mit einer katalytisch wirksamen Substanz bekannt, wobei zunächst eine poröse Trägerstruktur aufgebracht und anschließend mittels einer Plasmabehandlung unter Ausnutzung des Hohlkathodeneffektes die katalytische Substanz abgeschieden wird. Dabei werden die Prozessparameter so gewählt, dass nanogranulare Partikel mit Durchmessern zwischen 1 und 100 nm erhalten werden.

Katalytisch aktive Oberflächen, insbesondere von Abgaskatalysatoren werden heute in der Regel durch Aufbringung einer Beschichtung auf Basis einer wässrigen Suspension von Salzen der katalytischen Metalle, dem so genannten Washcoat, auf ein Trägersubstrat erzeugt. Die Überführung der eingesetzten Metallsalze in ihre katalytisch wirksame Form, dem elementaren Metall oder einem Metalloxid, erfolgt in einem Hochtemperaturschritt, dem Kalzinieren. Bei diesem Schritt wird auch die notwendige mechanische Festigkeit der Beschichtung erzielt. Neben der gewünschten Oxidation und Strukturbildung kommt es beim Kalzinieren jedoch auch zu Sintervorgängen, das heißt zur Agglomeration des katalytischen Materials, wodurch zunächst vorhandene Nanostrukturen teilweise oder sogar vollständig zerstört werden. Durch die mit dem Abbau der Nanostrukturen sinkende spezifische Oberfläche der katalytischen Beschichtung wird die katalytische Aktivität herabgesetzt. Insbesondere im Falle beschichteter Brennraumoberflächen oder brennraumnaher Oberflächen kommt es aufgrund der hohen Betriebstemperaturen im Lauf der Zeit ebenfalls zu Sinterungserscheinungen und damit zu einer Zerstörung eventuell vorhandener Mikro- oder Nanostrukturen.

Der vorliegenden Erfindung liegt die Aufgabe zugrunde, eine für den Brennraum von Verbrennungskraftmaschinen oder für brennraumnahe Bauteileoberflächen geeignete katalytische Beschichtung zur Verfügung zu stellen, die eine hohe katalytische Aktivität aufweist und keine oder eine nur niedrige Neigung zu Sinterungserscheinungen zeigt. Es soll ferner zumindest ein zur Erzeugung einer solchen Beschichtung geeignetes Verfahren zur Verfügung gestellt werden.

Diese Aufgaben werden durch eine Verbrennungskraftmaschine sowie durch die Verfahren mit den Merkmalen der unabhängigen Ansprüche gelöst. Weitere bevorzugte Ausgestaltungen der Erfindung ergeben sich aus den übrigen, in den Unteransprüchen genannten Merkmalen.

Gemäß ihrem ersten Aspekt betrifft die Erfindung eine Verbrennungskraftmaschine mit zumindest einem Brennraum, üblicherweise mit einer Mehrzahl von Brennräumen. Eine mit einem Luft-Kraftstoff-Gemisch oder einem Abgasstrom in Kontakt kommende Oberfläche zumindest eines Bauteils des Brennraums und/oder eines brennraumnahen, abgasströmungsführenden Bauteils der Verbrennungskraftmaschine, welches in thermischem Kontakt mit dem Brennraum steht, weist zumindest in Teilbereichen eine katalytische Beschichtung auf. Erfindungsgemäß weist die katalytische Beschichtung eine aus Strukturelementen länglicher Gestalt aufgebaute Nanostruktur auf. Die Strukturelemente weisen ein erstes Ende und ein zweites Ende auf und haften mit ihrem ersten Ende an der beschichteten Oberfläche, während ihr zweites Ende in dem Brennraum bzw. dem abgasströmungsführenden brennraumnahen Raum endet.

Dabei wird im Rahmen der vorliegenden Erfindung unter dem Begriff "Strukturelement länglicher Gestalt" ein die Beschichtung aufbauender Baustein verstanden, dessen Längsausdehnung ein Mehrfaches der Dimension des Durchmessers seiner orthogonal zu seiner Längsausdehnung verlaufenden Querschnittsfläche beträgt. Somit weisen die Strukturelemente eine im Wesentlichen zweidimensional verlaufende faserartige oder säulenartige Gestalt auf, die nur mit einem ihrer beiden Enden an der beschichteten Oberfläche gebunden vorliegen, während ihr zweites Ende frei in den gemisch- oder abgasführenden Raum hineinragt. Ferner wird unter dem Begriff "brennraumnah" ein Bauteil der Verbrennungskraftmaschine verstanden, der einlass- oder auslassseitig mit dem Brennraum und in thermischen Kontakt zu diesem in Verbindung steht.

Durch die erfindungsgemäße spezifische Nanostruktur der katalytischen Beschichtung wird erstens eine große spezifische, mit dem Luft-Kraftstoff-Gemisch oder dem Abgasstrom in Kontakt kommende Oberfläche erreicht. Auf diese Weise können trotz der naturgemäß extrem kurzen im Motor auftretenden Kontaktzeiten eine hohe katalytische Aktivität und hohe Umsatzraten gewährleistet werden. Ferner wird durch den aus länglichen Strukturelementen gebildeten Aufbau der Beschichtung erreicht, dass die Strukturelemente untereinander im Wesentlichen nicht oder nur in geringem Maß stofflich verbunden sind, d.h. allenfalls einander berühren. Auf diese Weise bildet die zwischen zwei Strukturelementen vorhandene Grenze ein natürliches Hindernis für deren Verschmelzung miteinander aus. Somit kann auch bei den hohen im Brennraum vorliegenden Temperaturen einem Sintern der Beschichtung, insbesondere eines katalytisch aktiven Metalls entgegengewirkt werden. Die durch die beschriebene Nanostruktur verursachte große Oberfläche der Beschichtung bleibt daher über die Lebensdauer der Verbrennungskraftmaschine erhalten. Es hat sich ferner gezeigt, dass die erfindungsgemäße Beschichtung auch bei hohen Temperaturen eine hohe mechanische Stabilität und Haftfestigkeit auf dem beschichteten Substrat, zum Beispiel Stahl oder Aluminium, aufweist, so dass sie für den Einsatz in Brennräumen sehr geeignet ist.

In bevorzugter Ausgestaltung der Erfindung weist die katalytische Beschichtung eine so genannte kolumnare Struktur auf, die aus säulenartig ausgestalteten Strukturelementen aufgebaut ist. Abhängig von dem gewählten Herstellungsverfahren können die Strukturelemente jedoch auch eine faserartige Struktur aufweisen.

Die erfindungsgemäße katalytische Beschichtung besitzt eine Nanostruktur. Unter diesem Begriff wird vorliegend verstanden, dass die Strukturelemente bei Draufsicht auf die Beschichtung im Wesentlichen orthogonal zu der beschichteten Oberfläche eine Dimension von maximal 5000 nm aufweisen. In bevorzugter Ausführung beträgt ein mittlerer Durchmesser der Querschnittsebene der Strukturelemente, welche im Wesentlichen parallel zu der beschichteten Oberfläche und orthogonal zur Längsausdehnung der Strukturelemente verläuft, höchstens 1000 nm, vorzugsweise 1 bis 500 nm. In einer bevorzugten Ausführung weist die Querschnittsebene einen mittleren Durchmesser im Bereich von 5 bis 100 nm auf, besonders bevorzugt von 10 bis 50 nm. Andererseits beträgt die im Wesentlichen durch die Längsausdehnung der Strukturelemente der Beschichtung bestimmte Schichtdicke derselben üblicherweise ein Mehrfaches ihrer Querdurchmesser. Insbesondere werden Schichtdicken bzw. Längen der Strukturelemente im Bereich von 0,1 bis 50 µm bevorzugt, vorzugsweise im Bereich von 0,5 bis 20 µm. Diese im Vergleich zu üblichen Washcoat-Beschichtungen relativ geringen Schichtdicken weisen verschiedene Vorteile auf. Während für langsame chemische Reaktionen eher dicke Schichten im Bereich bis zu mehreren 100 µm benötigt werden, sind für die Katalyse von schnellen Verbrennungsreaktionen nur wenige µm oder weniger erforderlich. Dicke Schichten bedeuten hier einen unnötig hohen Materialeinsatz der teuren Katalysatorelemente, insbesondere der Platingruppenmetalle (PGM). Ferner wird mit dünnen Schichten in der Regel eine bessere Haftfestigkeit im thermozyklischen Betrieb des Verbrennungsmotors erzielt. Schließlich weisen dünne Schichten im Vergleich zu dickeren auch einen geringeren Strömungswiderstand auf.

Vorzugsweise sind die Strukturelemente untereinander stofflich nicht (quer)verbunden, wodurch eine optimale Hemmung der Sintervorgänge erzielt wird. Dabei kann auch eine voneinander beabstandete Anordnung der Strukturelemente vorgesehen sein.

Mit den weiter unten beschriebenen Herstellungsverfahren lassen sich theoretisch beliebige Materialdichten der Beschichtung erzeugen. Vorzugsweise weist die Beschichtung eine Raumausfüllung im Bereich von 5 bis 95 Vol.-%, insbesondere im Bereich von 30 bis 80 Vol.%, auf. Besonders bevorzugt ist eine Raumausfüllung im Bereich von 50 bis 70 Vol.-%. Bei einer zu groß gewählten Dichte sinkt die aktive Oberfläche der Beschichtung, so dass ihre Aktivität abnimmt. Auf der anderen Seite sinkt bei zu niedrigen Dichten die mechanische Stabilität der Beschichtung.

Aus materieller Hinsicht wird das Beschichtungsmaterial so gewählt, dass einerseits der gewünschte katalytische Effekt erzielt wird und andererseits eine ausreichend hohe spezifische Oberfläche des Materials sowie eine ausreichende mechanische Stabilität und Haftfestigkeit erreicht werden. Hinsichtlich des ersten Aspektes wird das katalytische Material der Beschichtung so gewählt, dass eine Oxidation von unverbrannten oder teilverbrannten Kohlenwasserstoffen des Kraftstoffs sowie kohlenstoffhaltiger Verbrennungsrückstände katalytisch unterstützt wird. Hierdurch können kohlenstoffhaltige Ablagerungen auf Brennraumteilen und/oder auf motornahen Bauteilen vermieden und eine Reduzierung von Schadstoffemissionen (Partikel, HC) erzielt werden. Gleichzeitig wird die Kinetik von Verbrennungsvorreaktionen in Wandnähe des Brennraums beeinflusst. Somit kann auch die Bildung von Verbrennungsvorprodukten, Verbrennungsprodukten und Schadstoffemissionen günstig beeinflusst werden. Darüber hinaus werden Verschleißerscheinungen und Fehlfunktionen, die an verschiedenen Bauteilen durch Rußablagerungen verursacht werden können, vermieden. Die gewünschte Oxidation von kohlenstoffhaltigen Ablagerungen und unverbrannten Kohlenwasserstoffen wird durch zumindest ein katalytisch aktives, metallisch und/oder oxidisch vorliegendes Übergangsmetall und/oder Edelmetall in der Beschichtung erreicht. Dabei ist das zumindest eine Edelmetall vorzugsweise aus der Gruppe bestehend aus Pt, Pd und Rh (PGM), Ni, Cu, Ag und Au gewählt. Die vorgenannten Edelmetalle können dabei elementar als Metall (Oxidationsstufe Null), als Oxid oder in Mischformen vorliegen. Ferner wird das zumindest eine Übergangsmetall bevorzugt aus der Gruppe aus Co, Fe, Mo, Nb, V, W, Cu und Cr gewählt, wobei diese Metalle vorzugsweise als Oxide in der Beschichtung vorliegen.

Gemäß einer bevorzugten Ausgestaltung der Erfindung enthält die Beschichtung eine Kombination aus dem zumindest einen katalytisch aktiven Übergangsmetall und/oder Edelmetall und zumindest einem Trägermetalloxid. Letzteres weist einerseits die Funktion eines Trägers und/oder einer Matrix für das katalytisch aktive Übergangs- und/oder Edelmetall auf, so dass dieses auf und/oder in dem Trägermetalloxid fixiert wird. Andererseits kann das zumindest eine Trägermetalloxid eine oberflächenvergrößernde Funktion haben. Bei geeigneter Auswahl des Trägermetalloxids ist darüber hinaus möglich, dass dieses durch seine Fähigkeit, Sauerstoff reversibel zu speichern, sowie durch die Ionenleitung von Sauerstoff die katalysierte Oxidationsreaktion unterstützt. Vorzugsweise ist das zumindest eine Trägermetalloxid ausgewählt aus Oxiden der Metalle der Gruppen IIa, IVa, IIIb, IVb und Vb des Periodensystems der Elemente sowie der Seltenerdmetalle. Es ist besonders bevorzugt, dass das Trägermetalloxid CeO₂, ZrO₂, TiO₂, Al₂O₃ und/oder SiO₂ umfasst.

Das Gewichtsverhältnis von Trägermetalloxid zu dem/den katalytisch aktiven Übergangsmetallen und/oder Edelmetallen kann in breitem Maße variieren. Tendenziell überwiegt das Trägermetalloxid gegenüber dem katalytisch aktiven Metall, so dass letzteres als Dotierung des Trägermetalloxids angesehen werden kann. Insbesondere liegt das Gewichtsverhältnis von Trägermetalloxid/en zu Übergangs- und/oder Edelmetall/en im Bereich von 1000:1 bis 1:1 oder im Bereich von 300:1 bis 10:1, typischerweise im Bereich von 30:1 bis 10:1.

Bezüglich der Verteilungsarten des katalytisch aktiven Metalls in dem zumindest einen Trägermetalloxid sind unterschiedliche Ausführungen denkbar. Zunächst kann das zumindest eine Übergangsmetall und/oder Edelmetall in im Wesentlichen homogener Verteilung in dem zumindest einen Trägermetalloxid vorliegen. Diese Ausführung führt zu einer besonders hohen mechanischen und thermischen Stabilität der Beschichtung, weswegen sie für besonders stark mechanisch oder thermisch beanspruchte Bauteile, insbesondere also im Brennraum von Vorteil sein kann. Dabei ist denkbar, dass das zumindest eine katalytische Metall einen Konzentrationsgradienten innerhalb des Trägermetalloxids ausbilden kann, insbesondere mit einer in Richtung des gemisch- oder abgasführenden (Brenn)raums zunehmenden Konzentration, so dass die höchste Konzentration des katalytischen Metalls seitens des Brennraums bzw. des brennraumnahen Volumens vorliegt. In diesem Zusammenhang kann der genannte Konzentrationsgradient einen kontinuierlichen oder stufenweisen Verlauf haben. In einer alternativen Ausführung weist die Beschichtung einen schichtweisen Aufbau mit zumindest einer Schicht des Übergangsmetalls und/oder Edelmetalls auf, die mit Trägermetalloxidschichten abwechselt oder an eine solche angrenzt.

Die erfindungsgemäße Beschichtung kann mit Vorteil auf eine Vielzahl von Oberflächen der Verbrennungskraftmaschine, die mit dem Luft-Kraftstoff-Gemisch oder dem Abgasstrom in Kontakt kommen, vorgesehen sein. Insbesondere sind dies ein Kolbenboden, eine Zylinderinnenfläche, eine Zylinderkopfinnenfläche, ein Ventilboden und/oder eine Kehlung von Ein- und/oder Auslassventilen, eine Kraftstoffeinspritzdüse, eine Innenfläche eines Abgaskrümmers und/oder Abgasrohres, ein AGR-Ventil, ein AGR-Kühler und/oder eine abgasstromführende Fläche eines Abgasturboladers, insbesondere seines Verdichters.

In einem weiteren Aspekt betrifft die vorliegende Erfindung ein Verfahren zur Herstellung einer Beschichtung gemäß der vorliegenden Erfindung. Dabei erfolgt die Beschichtung vorzugsweise mit einem der PVD-Verfahren des Magnetronsputterns oder Gasflusssputterns. Diese Verfahren haben den Vorteil, dass bei geeigneter Wahl der Prozessparameter in einfacher Weise die erfindungsgemäße Nanostruktur der katalytischen Beschichtung, bestehend aus Strukturelementen länglicher Gestalt, insbesondere die kolumnare Nanostruktur, im Wege des Aufwachsens des abgeschiedenen Beschichtungsmaterials darstellbar ist. Ferner handelt es sich um Techniken mit geringem Zeit- und Energieaufwand, die zudem auch nur eine geringe thermische Belastung des zu beschichtenden Bauteils verursachen. Mit Vorteil lassen sich mit diesen beiden Sputterverfahren maßgeschneiderte nanoporöse Katalysatorschichten geringer Schichtdicken mit den bereits beschriebenen Vorteilen darstellen. Da während und nach der Abscheidung des Beschichtungsmaterials kein Hochtemperaturprozess erforderlich ist, bleibt die ursprünglich erzeugte Nanostruktur, insbesondere die kolumnare Struktur erhalten.

Die beiden genannten Sputterverfahren zählen zu den Verfahren der physikalischen Gasphasenabscheidung. Der Begriff "Physikalische Gasphasenabscheidung" (englisch: physical vapour deposition, kurz PVD) fasst verschiedene vakuumbasierte Beschichtungsverfahren zusammen, bei denen die Schicht durch Kondensation eines Materialdampfes des Beschichtungsmaterials auf dem zu beschichtenden Substrat hergestellt wird. Grundsätzlich wird das in fester Form vorliegende Beschichtungsmaterial (Target) - abhängig vom konkreten Verfahren - thermisch (thermisches Verdampfen), durch Beschuss mit Laserstrahlen (Laserstrahlverdampfen), mit Elektronen (Elektronenstrahlverdampfen), mit Ionen (Kathodenzerstäubung oder Sputterdeposition) oder anderen Methoden in einer evakuierten Kammer verdampft und auf dem Substrat abgeschieden. Das verdampfte Material kann dabei durch elektrische Felder in Richtung des Substrats geführt werden oder bewegt sich (in Abwesenheit elektrischer Felder) ballistisch. Beim dem hier interessierenden Sputtern (auch Kathodenzerstäubung oder Sputterdeposition genannt) wird das zu zerstäubende Target als Kathode geschaltet und mit energiereichen Ionen, zumeist Edelgasionen, beschossen, um so atomares Material aus dem Target herauszulösen und auf dem in der Nähe des Targets sich befindenden Substrat abzuscheiden. Bei der Magnetronzerstäubung (oder Magnetronsputtern) wird hinter dem Target ein Magnet angeordnet, so dass sich das erzeugte zusätzliche Magnetfeld mit dem elektrischen Feld überlagert. Die beiden Sputterverfahren der Magnetronzerstäubung und des Gasflusssputterns (GFS) ermöglichen in besonders einfacher Weise durch geeignete Wahl der Prozessparameter, wie Druck, elektrische Spannung, Magnetfeldstärke, etc. ein Abscheiden des Beschichtungsmaterials in der Art eines epitaktischen Kristallwachstums, wodurch die erfindungsgemäßen, insbesondere kolumnaren Strukturen in einfacher Weise erzeugt werden können.

Die vorstehend beschriebenen Strukturen, bei denen das zumindest eine katalytisch aktive Übergangsmetall und/oder Edelmetall in homogener Verteilung in dem zumindest einem Trägermetalloxid vorliegt, kann durch paralleles Co-Sputtern erzeugt werden, bei dem entweder sämtliche Materialien in einem Misch- bzw. Legierungstarget vorliegen oder bei dem mehrere einzelne Targets gleichzeitig abgetragen werden. Ist auf der anderen Seite eine Mehrlagenstruktur gewünscht, kann diese in einfacher Weise durch die genannten Sputterprozesse erzeugt werden, indem die entsprechenden Targets aufeinander folgend sukzessiv abgetragen und abgeschieden werden.

Die Erfindung wird nachfolgend in Ausführungsbeispielen anhand der zugehörigen Zeichnungen näher erläutert. Es zeigen:
- Figur 1: schematisch einen Zylinder einer Verbrennungskraftmaschine sowie brennraumnahe Bauteile,
- Figuren 2 und 3: Modellstrukturen der katalytischen Beschichtung gemäß verschiedenen Ausführungen der Erfindung,
- Figur 4: schematischer Aufbau einer Vorrichtung zum Gasflusssputtern,
- Figur 5: schematischer Aufbau einer Anlage zum Magnetronsputtern,
- Figuren 6 bis 9: REM-Bilder von mittels Gasflusssputtern hergestellten katalytischen Beschichtungen gemäß unterschiedlichen Ausführungen der vorliegenden Erfindung, und
- Figuren 10 bis 12: REM-Bilder von mittels Magnetronsputtern hergestellten katalytischen Beschichtungen gemäß unterschiedlichen Ausführungen der vorliegenden Erfindung.

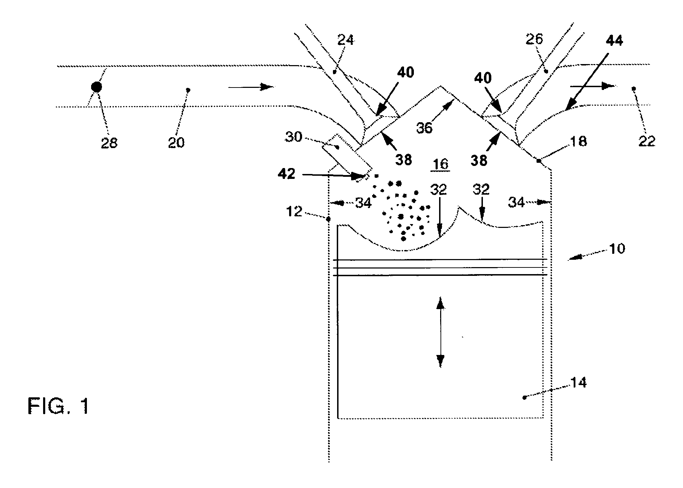

Figur 1 zeigt schematisch eine Schnittansicht brennraumrelevanter Komponenten einer selbstzündenden Verbrennungskraftmaschine, die gemäß der bevorzugten Ausführung der Erfindung als (selbstzündender) Dieselmotor ausgestaltet ist. Von der insgesamt mit 10 bezeichneten Verbrennungskraftmaschine ist vorliegend lediglich ein Zylinder 12 exemplarisch dargestellt. Selbstverständlich kann die Verbrennungskraftmaschine 10 über mehrere Zylinder 12 in unterschiedlichen Anordnungen verfügen. In dem Zylinder 12 ist axial beweglich ein Kolben 14 angeordnet, dessen Längsbewegung in eine Drehbewegung einer nicht dargestellten Kurbelwelle übertragen wird. Im Innenraum des Zylinders 12 wird ein Brennraum 16 durch den Kolben 14 einerseits und den Zylinder 12 andererseits eingeschlossen. In einem Zylinderkopf 18 des Zylinders 12 münden ein Einlasskanal 20, über den eine Luftzufuhr in den Brennraum 16 erfolgt, sowie ein Auslasskanal 22, welcher der Abführung des Abgases dient. Öffnung und Schließung von Einlasskanal 20 und Auslasskanal 22 erfolgen über ein Einlassventil 24 bzw. ein Auslassventil 26, welche üblicherweise über eine nicht dargestellte Nockenwelle asynchron gesteuert werden. Selbstverständlich können auch mehrere, jeweils mit entsprechenden Ventilen 24, 26 ausgestattete Ein- und Auslasskanäle 20, 22 pro Zylinder vorgesehen sein, beispielsweise jeweils zwei. Ein dem Brennraum 16 zuzuführender Luftmassenstrom wird lastabhängig durch eine steuerbare, im Einlasskanal 20 angeordnete Drosselklappe 28 geregelt. Im Zylinderkopf 18 ist ferner ein Hochdruckeinspritzventil 30 zur Einspritzung von Kraftstoff, insbesondere Dieselkraftstoff, in den Brennraum 16 angeordnet.

Wie bei Dieselmotoren üblich, erfolgt die Selbstzündung des im Brennraum 16 erzeugten Luft-Kraftstoff-Gemischs in Folge der Kompression durch den sich aufwärts bewegenden Kolben 14 im Kompressionstakt bei geschlossenen Ventilen 24, 26. Dabei verbrennt der Dieselkraftstoff hauptsächlich zu Kohlendioxid CO₂ und gewissen Mengen Kohlenmonoxid CO und unverbrannten oder teilweise verbrannten Kohlenwasserstoffen HC. Letztere führen bekanntermaßen zu Ablagerungen an verschiedenen Bauteilen des Brennraumes oder abgasführender Komponenten. Um diesen kohlenstoffhaltigen oder rußhaltigen Ablagerungen entgegenzuwirken, sind an verschiedenen Oberflächen katalytische Beschichtungen aufgebracht. Dies betrifft im Brennraum 16 insbesondere den Kolbenboden 32, die Zylinderinnenfläche 34 und/oder die Zylinderkopfinnenfläche 36. Ferner können die Ventilböden 38 von Einlassventil 24 und/oder Auslassventil 26 und/oder die Ventilkehlungen 40 katalytisch beschichtet sein. Auch eine Düse 42 des Einspritzventils 30 kann eine erfindungsgemäße katalytische Beschichtung erhalten, um so Funktionsausfälle in Folge von Ablagerungen zu vermeiden. Auch die Innenfläche 44 des auch als Abgaskrümmer bezeichneten Auslassrohres 22 kann zur Unterstützung der katalytischen Nachverbrennung von unverbrannten Kohlenwasserstoffen sowie zur Vermeidung von Ablagerung eine katalytische Beschichtung aufweisen. Nicht dargestellt in Figur 1 sind Bauteile einer Abgasrückführung (AGR), mit welchen Abgas aus dem Abgaskanal in das Einlassrohr 20 zurückgeführt wird. Im Rahmen der vorliegenden Erfindung kann auch ein hierzu gehöriges AGR-Ventil und/oder ein AGR-Kühler mit der erfindungsgemäßen katalytischen Beschichtung versehen sein. Ferner kann eine Innenfläche eines hier ebenfalls nicht dargestellten abgasbetriebenen Verdichters eines Abgasturboladers die katalytische Beschichtung aufweisen.

Neben der bereits angesprochenen Katalyse der Oxidation von unverbrannten oder teilweise verbrannten Kohlenwasserstoffen und Ruß kann die katalytische Beschichtung zusätzlich über wärmedämmende und/oder antiadhäsive Eigenschaften verfügen, um den Verbrennungsvorgang günstig zu beeinflussen bzw. Ablagerungen entgegenzuwirken.

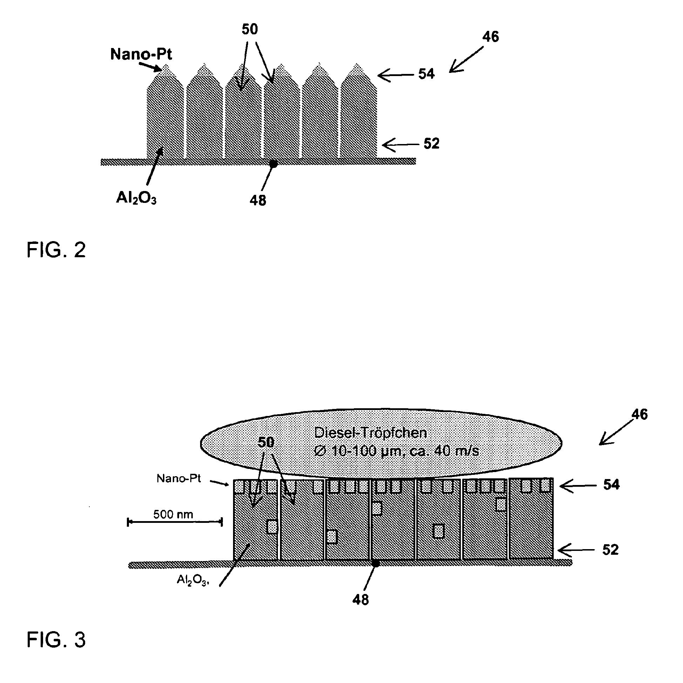

Figur 2 zeigt in stark vereinfachter schematischer Darstellung eine vorteilhafte Ausgestaltung einer erfindungsgemäßen katalytischen Beschichtung, die hier insgesamt mit 46 bezeichnet ist, wobei das beschichtete Substrat, beispielsweise ein Kolbenboden oder eine Zylinderinnenfläche, mit 48 bezeichnet ist. Das Substrat kann dabei typischerweise aus Stahl oder Aluminium hergestellt sein. Erfindungsgemäß ist die Beschichtung 46 im Wesentlichen aus länglichen Strukturelementen 50 aufgebaut, von denen hier exemplarisch 6 dargestellt sind. Die Strukturelemente 50 haben im dargestellten Beispiel eine kolumnare, das heißt säulenartige Gestalt mit einem ersten Ende 52, das an der beschichteten Oberfläche des Substrats 48 anhaftet, und einem zweiten Ende 54, das in dem mit dem Luft-Kraftstoff-Gemisch oder dem Abgasstrom in Kontakt kommenden Raum, beispielsweise einem Brennraum, endet. Gemäß dem dargestellten Ausführungsbeispiel weist die Beschichtung 46 eine Kombination aus einem Trägermetalloxid sowie zumindest einem katalytisch aktiven Metall oder Metalloxid auf. Gemäß dem gezeigten Bespiel macht das Trägermetalloxid, hier Al₂O₃, das Bulkvolumen der Strukturelemente 50 der Beschichtung aus und befindet sich insbesondere in unmittelbarem Kontakt mit dem beschichteten Substrat 48. Das katalytisch aktive Metall, das insbesondere ein Übergangsmetall und/oder ein Edelmetall und/oder deren Oxide umfasst, hier beispielsweise metallisches Platin Pt, ist hingegen im Wesentlichen an dem dem Brennraum zugewandten zweiten Ende 54 der Strukturelemente 50 konzentriert vorhanden. Auf diese Weise befinden sich fast sämtliche Atome des Platins auf der exponierten Oberfläche der Strukturelemente 50 und kann somit seine katalytische Aktivität im Zusammenhang mit der Oxidation von Kohlenwasserstoffen optimal entfalten. Das Trägeroxid Al₂O₃ dient einerseits als Träger für das katalytische Material Pt sowie seiner Fixierung auf dem Substrat 48 und auch der Erzeugung einer großen spezifischen Oberfläche. Im Falle von Al₂O₃ als Trägeroxid weist dieses zudem vorteilhafte sinterhemmende Eigenschaften auf, die ein Verschmelzen der separaten Strukturelemente 50 verhindern. Es ist in Figur 2 erkennbar, dass der Durchmesser der Strukturelemente 50 bezüglich ihrer Querschnittsfläche parallel zu dem Substrat 48 größer ist als der Durchmesser des katalytischen Materials. Beispielsweise beträgt der durchschnittliche Durchmesser der Strukturelemente im unteren Bereich höchstens 500 nm, während die Platinspitzen einen Durchmesser von beispielsweise 50 nm oder weniger aufweisen.

Figur 3 zeigt ein weiteres Modell einer erfindungsgemäßen katalytischen Beschichtung 46, wobei gleiche Elemente mit denselben Bezugszeichen wie in Figur 2 bezeichnet sind. Im Gegensatz zu der in Figur 2 gezeigten Struktur weisen hier die Strukturelemente 50 ein stumpfes brennraumzugewandtes zweites Ende 54 auf, das als eine Mischphase des Trägeroxids und des katalytischen Metalls vorliegt. Diese Struktur kann erzeugt werden, indem zunächst ein Target des reinen Trägermaterials Al₂O₃ bzw. des reinen Aluminiummetalls und anschließend ein AlPt-Mischtarget oder zwei separate Al- und Pt-Targets co-gesputtert werden. In Figur 3 ist ferner schematisch ein Dieseltröpfchen angedeutet, das sich mit einer typischen Geschwindigkeit von zirka 40 m/s auf der Beschichtung 46 abschlägt und einen typischen Durchmesser von 10-100 µm aufweist. Es ist erkennbar, dass dieser Kraftstofftropfen hauptsächlich in Kontakt mit dem katalytischen Metall Pt kommt, welches so in vorteilhafter Weise seine Oxidation katalysiert.

Grundsätzlich werden die auf dem Substrat 48 erzeugten Strukturgrößen durch die Dimensionen der beim Sputtern erzeugten Primärpartikel bestimmt. Diese wiederum lassen sich durch geeignete Wahl der Prozessparameter der Sputterprozesse in einem weiten Bereich beeinflussen.

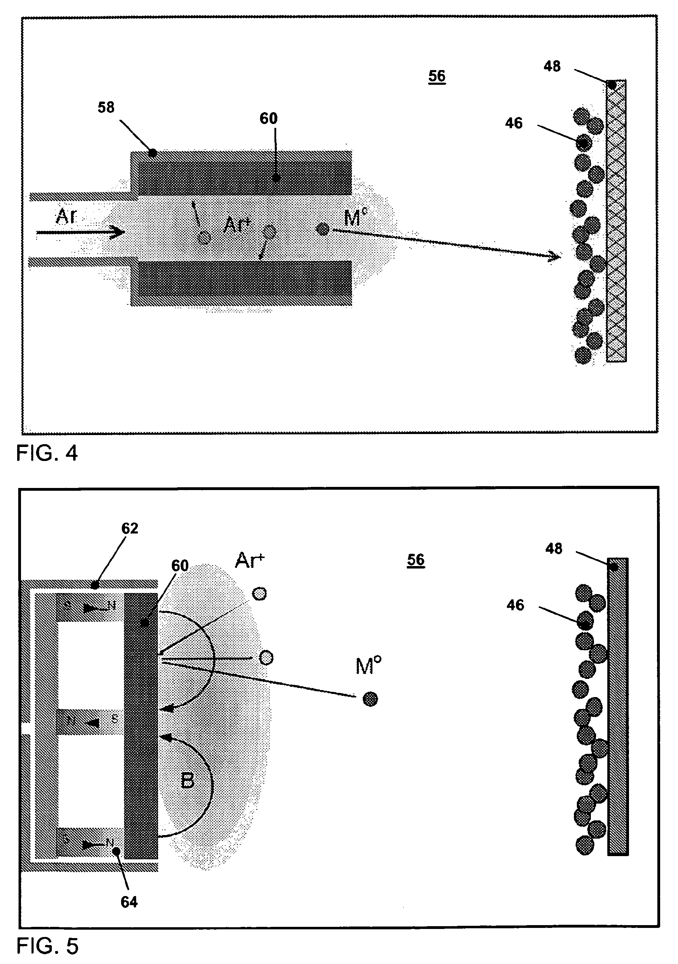

Figur 4 stellt in starker Vereinfachung den grundsätzlichen Aufbau einer Anlage zum Gasflusssputtern dar. Mit 48 ist wiederum das zu beschichtende Substrat und mit 46 die Beschichtung bezeichnet. Eine in einer Vakuumkammer 56 angeordnete Hohlkathode 58 weist auf ihrer Innenseite eine Oberfläche aus dem Targetmaterial 60 auf, die üblicherweise aus der Metallkomponente des Beschichtungsmaterials besteht. Durch die Hohlkathode 58 wird ein Arbeitsgas, beispielsweise Argon Ar, geleitet und durch die Hohlkathodenentladung teilweise ionisiert. Die Argonionen Ar⁺ werden zur Oberfläche des Targets 60 beschleunigt und schlagen beim Auftreffen einzelne Atome M⁰ des Targetmaterials heraus. Diese werden mit dem Argongasstrom auf das ebenfalls in der Vakuumkammer angeordnete zu beschichtende Substrat 48 geleitet, wo sich die Atome M⁰ des Beschichtungsmaterials oder Primärpartikel derselben abscheiden und zu einer Beschichtung 46 aufwachsen. Die Beschichtung erfolgt vorzugsweise bei einem Totaldruck von 0,1 bis 10 mbar. Der Abstand zwischen Hohlkathode 58 und Substrat 48 beträgt typischerweise etwa 20 bis 400 mm. Zur Einstellung der gewünschten Schichtstruktur kann das Substrat mit einer negativen Substratvorspannung im Bereich von 20 bis 200 V belegt werden.

Die in Figur 5 schematisiert dargestellte Anlage zum Magnetronsputtern umfasst ebenfalls eine Vakuumkammer 56, in welcher das zu beschichtende Substrat 48 sowie ein Target 60 des Beschichtungsmaterials, das mit einer Kathode 62 elektrisch kontaktiert, angeordnet sind. Zusätzlich ist unter dem Target 60 eine Magnetanordnung 64 vorgesehen, welche ein magnetisches Feld B erzeugt, welches mit dem elektrischen Feld überlagert. Wiederum wird in die Kammer 56 beispielsweise Argon als Arbeitsgas eingeleitet, das ionisiert wird und Atome M⁰ des Targetmaterials herausschlägt, welche sich auf dem Substrat 48 abscheiden. Durch das magnetische Feld werden die Ladungsträger abgelenkt und kreisen in einer Spiralbahn über der Target-Oberfläche, wodurch sich die Anzahl der Stöße erhöht und die Ionisierungsrate und der Sputterabtrag verstärkt werden.

Bei beiden vorgestellten Verfahren, dem Gasfluss- und dem Magnetronsputtern, ist der Arbeitsdruck von besonderer Bedeutung, um die zu aufzubauende Schichtstruktur zu beeinflussen. Insbesondere lässt sich die Raumausfüllung in Abhängigkeit von dem im Bereich von 0,01 bis 100 mbar gewählten Arbeitsdruck in einem weiten Bereich einstellen. Um die bevorzugten Raumausfüllungen zwischen 30 und 80 % zu erhalten, werden typischerweise Drücke von 0,05 bis 10 mbar, vorzugsweise von 0,1 bis 1 mbar, eingestellt. Ebenso kann bei beiden Verfahren das Substrat mit einer negativen Substratvorspannung belegt werden, um die gewünschte Schichtstruktur zu erhalten. Die Substratvorspannung kann zu diesem Zweck im Bereich von 1 bis 1000 V liegen, insbesondere im Bereich von 10 bis 500 V, vorzugsweise von 20 bis 200 V.

Sowohl beim Gasfluss- als auch beim Magnetronsputtern kann als Target 60 das Beschichtungsmaterial selbst oder, wenn dieses oxidisch abgeschieden werden soll, auch in Form des elementaren Metalls M⁰ eingesetzt werden. In letzterem Fall wird dem Arbeitsgas noch ein Reaktivgas zugemischt (z.B. Sauerstoff), das eine Oxidation des Metalls M⁰ bewirkt. Dieses Verfahren ist als reaktives Sputtern bekannt. Wenn beispielsweise eine Aluminiumoxidschicht abgeschieden werden soll, kann ein metallisches Aluminium-Target verwendet werden, wobei unter Einsatz von Sauerstoff als Reaktivgas die Oxidbildung nach folgender Reaktionsgleichung abläuft: 4 Al (Target 60) + 3 O₂ -> 2 Al₂O₃ (Schicht 46). Beim Co-Sputtern zur Erzeugung einer Metall-dotierten Trägeroxidschicht, beispielsweise Pt/Al₂O₃, kann ein Target, das aus einer Legierung aus Al und Pt besteht, verwendet werden, wobei durch den Sauerstoff lediglich das unedlere Aluminium oxidiert wird.

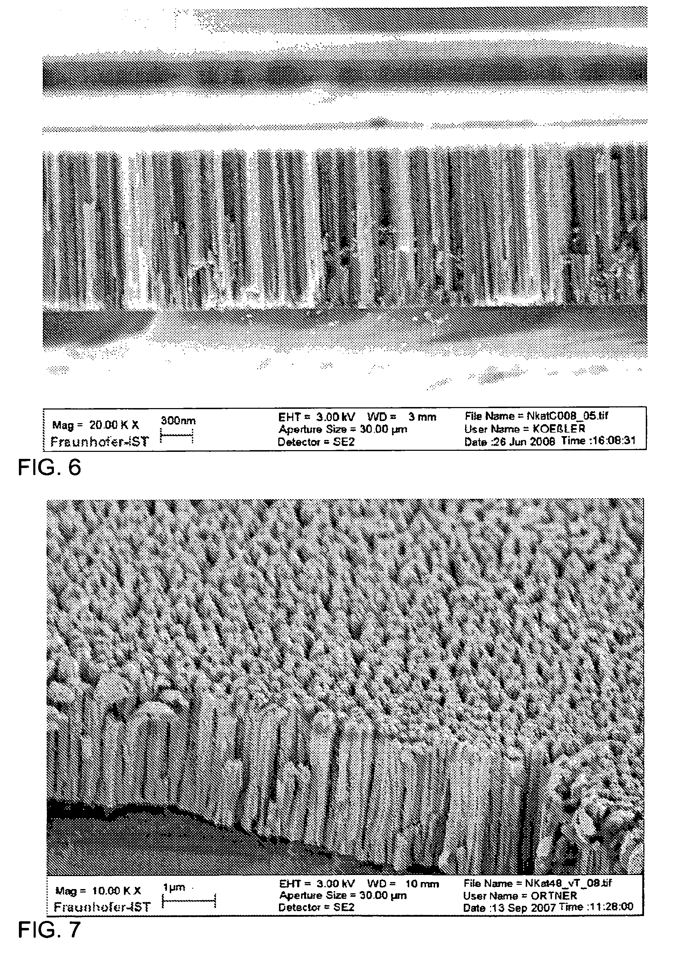

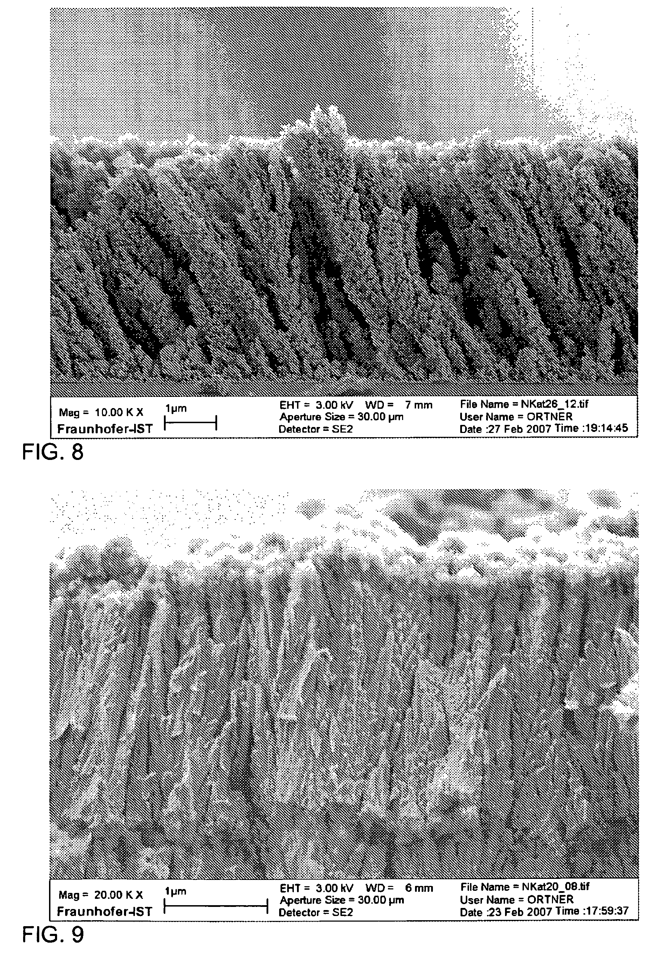

Die Figuren 6 bis 9 zeigen rasterelektronenmikroskopische Aufnahmen von erfindungsgemäßen katalytischen Beschichtungen, die mit dem Gasflusssputtern hergestellt worden sind. Die in Figur 6 deutlich zu erkennenden kolumnaren Strukturelemente bestehen aus CeO₂, das im Wege des reaktiven Gasflusssputterns, d.h. mit einem metallischen Ce-Target in einer oxidierenden Atmosphäre hergestellt, wurde. Hingegen zeigen die Figuren 7 bis 9 jeweils Beschichtungen aus Al₂O₃ und Platin an den äußersten Enden der faserartigen oder kolumnaren Strukturelemente, das heißt an den beispielsweise dem Brennraum zugewandten freien Enden der Strukturelemente. Es ist erkennbar, dass durch Beeinflussung der Prozessparameter des Gasflusssputterns sehr unterschiedliche Materialdichten erzeugt werden können. Während die in den Figuren 7 und 8 gezeigten Beschichtungen eine vergleichsweise poröse Struktur aufweisen, weist die in Figur 9 gezeigte Beschichtung eine relativ hohe Kompaktheit auf.

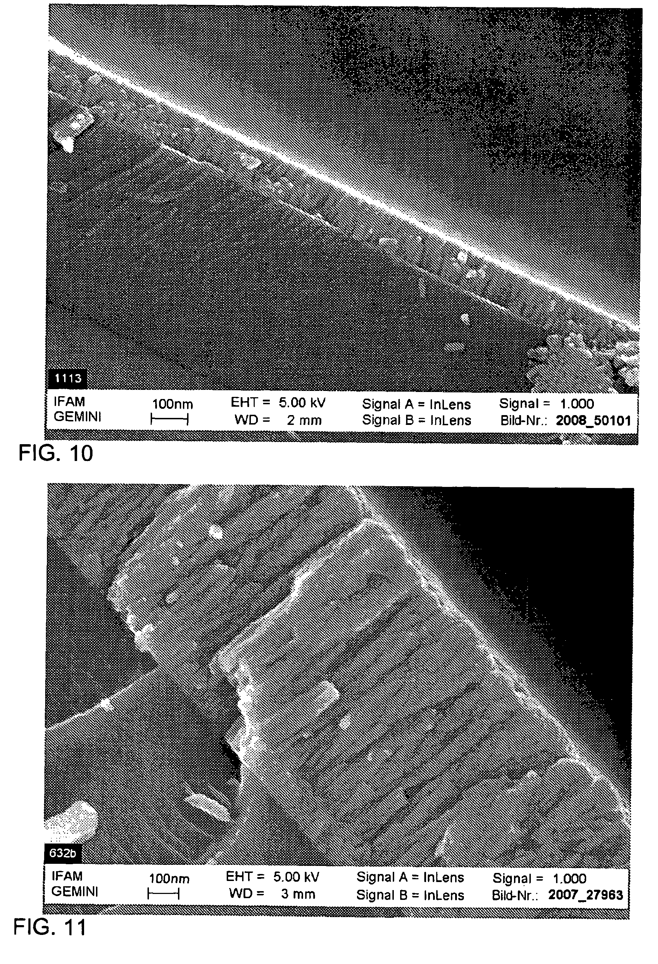

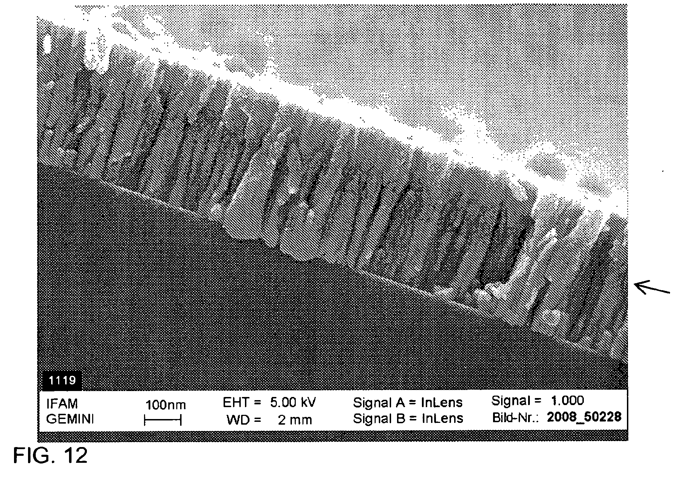

Die in den Figuren 10 bis 12 abgebildeten REM-Bilder zeigen Beschichtungen aus SiO₂ als Trägeroxid und Cobalt Co als katalytisches Metall, die mit dem Magnetron-Verfahren hergestellt wurden. Dabei wurden die Beschichtungen gemäß Figur 10 und 11 durch Co-Sputtern des katalytisches Metalls und des Trägeroxids hergestellt, so dass das katalytische Metall homogen im trägeroxid verteilt vorliegt (Co : SiO₂ = 1:2, Primärpartikelgröße 10-20 nm). Hingegen erfolgte die Herstellung der Beschichtung nach Figur 12 durch sukzessives Sputtern zunächst einer Schicht des Trägermetalls, dann einer Schicht des Katalysators und schließlich einer weiteren Trägermetallschicht. Die Co-Katalysatorschicht ist als dunkle Zwischenschicht orthogonal zur kolumnaren Ausrichtung erkennbar (siehe Pfeil).

### Bezugszeichenliste

- 10: Verbrennungskraftmaschine
- 12: Zylinder
- 14: Kolben
- 16: Brennraum
- 18: Zylinderkopf
- 20: Einlassrohr
- 22: Auslassrohr / Abgaskrümmer
- 24: Einlassventil
- 26: Auslassventil
- 28: Drosselklappe
- 30: Einspritzventil
- 32: Kolbenboden
- 34: Zylinderinnenfläche
- 36: Zylinderkopffläche
- 38: Ventilboden
- 40: Ventilkehlung
- 42: Düse
- 44: Abgaskrümmerinnenfläche
- 46: katalytische Beschichtung
- 48: Substrat
- 50: Strukturelemente
- 52: erstes Ende
- 54: zweites Ende
- 56: Vakuumkammer
- 58: Hohlkathode
- 60: Target
- 62: Kathode
- 64: Magnetanordnung

## Patentansprüche

1. Verbrennungskraftmaschine (10) mit zumindest einem Brennraum (16), wobei eine mit einem Luft-Kraftstoff-Gemisch oder einem Abgasstrom in Kontakt kommende Oberfläche zumindest eines Bauteils des Brennraums (16) und/oder eines brennraumnahen, abgasströmungsführenden Bauteils der Verbrennungskraftmaschine (10) zumindest bereichsweise eine katalytische Beschichtung (46) aufweist,
**dadurch gekennzeichnet, dass**
die katalytische Beschichtung (46) eine aus Strukturelementen (50) länglicher Gestalt aufgebaute Nanostruktur aufweist, wobei die Strukturelemente (50) mit ihrem ersten Ende (52) an der beschichteten Oberfläche anhaften und mit ihrem zweiten Ende (54) in dem Brennraum (16) oder dem abgasströmungsführenden Raum enden.

2. Verbrennungskraftmaschine nach Anspruch 1,
**dadurch gekennzeichnet, dass**
die katalytische Beschichtung eine kolumnare, aus säulenartigen Strukturelementen (50) aufgebaute Nanostruktur aufweist.

3. Verbrennungskraftmaschine nach einem der vorhergehenden Ansprüche,
**dadurch gekennzeichnet, dass**
die Strukturelemente (50) untereinander nicht querverbunden sind.

4. Verbrennungskraftmaschine nach einem der vorhergehenden Ansprüche,
**dadurch gekennzeichnet, dass**
ein mittlerer Durchmesser einer im Wesentlichen parallel zur beschichteten Oberfläche verlaufenden Querschnittsebene der Strukturelemente (50) höchstens 1000 nm beträgt, insbesondere im Bereich von 5 bis 100 nm liegt, vorzugsweise im Bereich von 10 bis 50 nm.

5. Verbrennungskraftmaschine nach einem der vorhergehenden Ansprüche,
**dadurch gekennzeichnet, dass**
die Beschichtung (46) eine Raumausfüllung im Bereich von 5 bis 95 % aufweisen, insbesondere im Bereich von 30 bis 80 %.

6. Verbrennungskraftmaschine nach einem der vorhergehenden Ansprüche,
**dadurch gekennzeichnet, dass**
die Beschichtung zumindest ein katalytisch aktives, metallisch und/oder oxidisch vorliegendes Übergangsmetall und/oder Edelmetall aufweist.

7. Verbrennungskraftmaschine nach Anspruch 6,
**dadurch gekennzeichnet, dass**
zumindest ein Edelmetall ausgewählt ist aus der Gruppe bestehend aus Pt, Pd, Rh, Ni, Cu, Ag und Au.

8. Verbrennungskraftmaschine nach Anspruch 6,
**dadurch gekennzeichnet, dass**
zumindest ein Übergangsmetall ausgewählt ist aus der Gruppe bestehend aus Co, Fe, Mo, Nb, V, W, Cu und Cr.

9. Verbrennungskraftmaschine nach einem der Ansprüche 6 bis 8,
**dadurch gekennzeichnet, dass**
die Beschichtung eine Kombination aus dem zumindest einen katalytisch aktiven Übergangsmetall und/oder Edelmetall und zumindest einem Trägermetalloxid umfasst, wobei das zumindest eine Trägermetalloxid einen Träger und/oder eine Matrix für das zumindest eine Übergangsmetall und/oder Edelmetall darstellt.

10. Verbrennungskraftmaschine nach einem der vorhergehenden Ansprüche,
**dadurch gekennzeichnet, dass**
zumindest ein Trägermetalloxid ausgewählt ist aus Oxiden der Metalle der PSE-Gruppen IIa, IVa, IIIb, IVb, Vb, und der Seltenerdmetalle, insbesondere aus der Gruppe bestehend aus CeO₂, ZrO₂, TiO₂, Al₂O₃ und SiO₂.

11. Verbrennungskraftmaschine nach einem der Ansprüche 9 bis 10,
**dadurch gekennzeichnet, dass**
ein Gewichtsverhältnis des zumindest einen Trägermetalloxids zu dem zumindest einen katalytisch aktiven Übergangsmetall und/oder Edelmetall im Bereich von 1000:1 bis 1:1, insbesondere im Bereich von 300:1 bis 10:1 liegt, vorzugsweise im Bereich von 30:1 bis 10:1 liegt.

12. Verbrennungskraftmaschine nach Anspruch 9 oder 10,
**dadurch gekennzeichnet, dass**
das zumindest eine Übergangsmetall und/oder Edelmetall in homogener Verteilung in dem zumindest einen Trägermetalloxid vorliegt oder einen Konzentrationsgradienten innerhalb des zumindest einen Trägermetalloxids ausbildet oder in zumindest einer eigenen Schicht vorliegt.

13. Verbrennungskraftmaschine nach Anspruch 9 oder 10,
**dadurch gekennzeichnet, dass**
die mit dem Luft-Kraftstoff-Gemisch oder dem Abgasstrom in Kontakt kommende Oberfläche ein Kolbenboden (32), eine Zylinderinnenfläche (34), eine Zylinderkopffläche (36), eine Kehlung (40) und/oder ein Ventilboden (38) von Ein- und/oder Auslassventilen (24, 26), eine Kraftstoffeinspritzdüse (42), eine Innenfläche (44) eines Abgaskrümmers und/oder Abgasrohres, ein AGR-Ventil, ein AGR-Kühler und/oder eine Innenfläche eines Abgasturboladers, insbesondere seines Verdichters, umfasst.

14. Verfahren zur Herstellung einer Beschichtung einer mit einem zu verbrennenden Luft-Kraftstoff-Gemisch oder einem Abgasstrom in Kontakt kommenden Oberfläche zumindest eines Bauteils eines Brennraums und/oder eines brennraumnahen, abgasströmungsführenden Bauteils einer Verbrennungskraftmaschine nach einem der Ansprüche 1 bis 13,
**dadurch gekennzeichnet, dass**
die Beschichtung durch Magnetronsputtern oder durch Gasflusssputtern erfolgt, wobei während des Magnetronsputterns oder Gasflusssputterns ein Arbeitsdruck im Bereich von 0,01 bis 100 mbar eingestellt und das Bauteil mit einer negativen Substratvorspannung belegt wird.

15. Verfahren nach Anspruch 14,
**dadurch gekennzeichnet, dass**
ein Arbeitsdruck während des Magnetronsputterns oder Gasflusssputterns von im Bereich von 0,05 bis 10 mbar, vorzugsweise von 0,1 bis 1 mbar, eingestellt wird.

16. Verfahren nach Anspruch 14 oder 15,
**dadurch gekennzeichnet, dass**
zumindest ein katalytisch aktives Übergangsmetall und/oder Edelmetall und zumindest ein Trägermetalloxid durch paralleles Co-Sputtern oder sukzessiv aufeinander folgend abgeschieden werden.

## Claims

1. An internal combustion engine (10) having at least one combustion chamber (16), wherein a surface of at least one component of the combustion chamber (16) and/or of a component of the internalcombustionengine (10), which component is close to the combustion chamber and carries the exhaust gas flow, has a catalytic coating (46) at least in certain areas, said surface coming into contact with an air-fuel mixture or an exhaust gas flow,
**characterized in that**
the catalyticcoating (46) has a nanostructure composed of structural elements (50) having an elongated shape, wherein the structural elements (50) adhere with their first ends (52) to the coated surface and end with their second ends (54) in the combustion chamber (16) or the chamber that carries the exhaust gas flow.

2. The internal combustion engine according to claim 1,
**characterized in that**
that the catalytic coating has a columnar nanostructure composed of column-like structural elements (50).

3. The internal combustion engine according to any one of the preceding claims,
**characterized in that**
the structural elements (50) are not cross-connected to each other.

4. The internal combustion engine according to any one of the preceding claims,
**characterized in that**
a mean diameter of a cross-sectional plane of the structural elements (50), which cross-sectional plane runs substantially parallel to the coated surface, is at most 1000 nm, lies in particular in a range of from 5 to 100 nm, preferably in the range of from 10 to 50 nm.

5. The internal combustion engine according to any one of the preceding claims,
**characterized in that**
the coating (46) has a volume ratio in the range of from 5 to 95%, in particular in the range of from 30 to 80%.

6. The internal combustion engine according to any one of the preceding claims,
**characterized in that**
the coating comprises at least one catalytically active, metallic and/or oxidictransition metal and/or noble metal.

7. An internal combustion engine according to claim 6,
**characterized in that**
at least one noble metal is selected from the group consisting of Pt, Pd, Rh, Ni, Cu, Ag and Au.

8. The internal combustion engine according to claim 6,
**characterized in that**
at least one transition metal is selected from the group consisting of Co, Fe, Mo, Nb, V, W, Cu and Cr.

9. The internal combustion engine according to any of the claims 6 to 8,
**characterized in that**
the coating comprises a combination of the at least one catalytically active transition metal and/or noble metal and at least one carrier metal oxide, wherein the at least one carrier metal oxide represents a carrier and/or a matrix for the at least one transition metal and/or noble metal.

10. The internal combustion engine according to any one of the preceding claims,
**characterized in that**
at least one carrier metal oxide is selected from oxides of the metals of the groups IIa, IVa, IIIb, IVb, Vb of the periodic table of elements and of the rare-earth metals, in particular from the group consisting of CeO₂, ZrO₂, TiO₂, Al₂O₃ and SiO₂.

11. The internal combustion engine according to any one of the claims 9 to 10,
**characterized in that**
a weight ratio of the at least one carrier metal oxide to the at least one catalytically active transition metal and/or noble metal is in the range of from 1000:1 to 1:1, in particular in the range of from 300:1 to 10:1, preferably in the range of 30:1 to 10:1.

12. The internal combustion engine according to claim 9 or claim 10,
**characterized in that**
the at least one transition metal and/or noble metal is present homogenously distributed in the at least one carrier metal oxide, or develops a concentration gradient within the at least one carrier metal oxide, or is present in at least one layer of its own.

13. The internal combustion engine according to claim 9 or claim 10,
**characterized in that**
the surface which comes into contact with the air-fuel mixture or the exhaust gas flow comprises a piston head (32), an inner surface (34) of the cylinder, a cylinder head surface (36), a groove (40) and/or a valve bottom (38) of intake and/or outlet valves (24, 26), a fuel injection nozzle (42), an inner surface (44) of an exhaust manifold and/or exhaust pipe, an EGR valve, an EGR cooler and/or an inner surface of an exhaust gas turbocharger, in particular of the compressor thereof.

14. A method for producing a coating on a surface of at least one component of a combustion chamber and/or of a component of an internalcombustionengine, which component is close to the combustion chamber and carries the exhaust gas flow, said surface coming into contact with an air-fuel mixture to be combusted or with an exhaust gas flow, according to any one of the claim 1 to 13,
**characterized in that**
coating is carried out by magneton sputtering or gas flow sputtering, wherein during magneton sputtering or gas flow sputtering, a working pressure is set in the range of from 0.01 to 100 mbar and the component is subjected to a negative substrate bias voltage.

15. The method according to claim 14,
**characterized in that**
a working pressure in the range of from 0.05 to 10 mbar, preferably from 0.1 to 1 mbar, is set during magnetron sputtering or gas flow sputtering.

16. The method according to claim 14 or claim 15,
**characterized in that**
at least one catalytically active transition metal and/or noble metal and at least one carrier metal oxide are deposited by parallel co-sputtering or successive sputtering.

## Revendications

1. Moteur à combustion interne (10) avec au moins une chambre de combustion (16), pour lequel une surface entrant en contact avec un mélange air-carburant ou un flux de gaz d'échappement d'au moins un composant de la chambre de combustion (16) et/ou d'un composant à proximité de la chambre de combustion, guidant l'écoulement des gaz d'échappement du moteur à combustion interne (10) présente au moins par zone un revêtement catalytique (46) **caractérisé en ce que** le revêtement (46) catalytique présente une nanostructure constituée d'éléments structuraux (50) de configuration longitudinale, pour laquelle les éléments structuraux (50) adhérent à leur première extrémité (52) à la surface revêtue et se terminent à leur deuxième extrémité (54) dans la chambre de combustion (16) ou dans le compartiment guidant l'écoulement de gaz d'échappement.

2. Moteur à combustion interne selon la revendication 1 **caractérisé en ce que** le revêtement catalytique présente une nanostructure en colonnes constituée d'éléments structuraux (50) colonnaires.

3. Moteur à combustion interne selon une des revendications précédentes **caractérisé en ce que** les éléments structuraux (50) ne sont pas reliés entre eux transversalement.

4. Moteur à combustion interne selon une des revendications précédentes **caractérisé en ce qu'**un diamètre moyen d'un plan transversal des éléments structuraux (50) passant pour l'essentiel parallèlement à la surface revêtue est au maximum de 1000 nm, est en particulier de l'ordre de 5 à 100 nm, de préférence de l'ordre de 10 à 50 nm.

5. Moteur à combustion interne selon une des revendications précédentes **caractérisé en ce que** le revêtement (46) présente un remplissage spatial de l'ordre de 5 à 95 %, en particulier de l'ordre de 30 à 80%.

6. Moteur à combustion interne selon une des revendications précédentes **caractérisé en ce que** le revêtement présente au moins un métal de transition et/ou métal précieux actif du point de vue catalytique, présent par voie métallique et/ou d'oxydation.

7. Moteur à combustion interne selon la revendication 6 **caractérisé en ce qu'**au moins un métal précieux est choisi à partir du groupe composé de Pt, Pd, Rh, Ni, Cu, Ag et d'Au.

8. Moteur à combustion interne selon la revendication 6 **caractérisé en ce qu'**au moins un métal de transition est choisi à partir du groupe composé de Co, Fe, Mo, Nb, V, W, Cu et de Cr.

9. Moteur à combustion interne selon une des revendications 6 à 8 **caractérisé en ce que** le revêtement comprend une combinaison d'au moins un métal de transition et/ou métal précieux actif du point de vue catalytique et d'au moins un oxyde métallique porteur, pour lequel au moins ledit oxyde métallique porteur représente un porteur et/ou une matrice pour au moins ledit métal de transition et/ou métal précieux.

10. Moteur à combustion interne selon une des revendications précédentes **caractérisé en ce qu'**au moins un oxyde métallique porteur est choisi à partir des oxydes des métaux du groupe à système périodique des éléments (SPE) chimiques IIa, IVa, IIIb, IVb, Vb et des métaux des terres rares, en particulier du groupe composé de CeCO₂, ZrO₂, TiO₂, Al₂O₃ et SiO₂.

11. Moteur à combustion interne selon une des revendications 9 à 10 **caractérisé en ce qu'**un rapport pondéral entre au moins ledit oxyde métallique porteur et au moins ledit métal de transition et/ou métal précieux actif du point de vue catalytique est de l'ordre de 1000:1 à 1:1, en particulier de l'ordre de 300:1 à 10:1, de préférence de l'ordre de 30:1 à 10:1.

12. Moteur à combustion interne selon une des revendications 9 ou 10 **caractérisé en ce qu'**au moins ledit métal de transition et/métal précieux est présent en répartition homogène dans au moins ledit oxyde métallique porteur ou constitue un gradient de concentration à l'intérieur au moins dudit oxyde métallique porteur ou est présent dans au moins une couche propre.

13. Moteur à combustion interne selon la revendication 9 ou 10 **caractérisé en ce que** la surface entrant en contact avec le mélange air-carburant ou le flux de gaz d'échappement comprend un fond de piston (32), une surface intérieure de cylindre (34), une surface de culasse (36), une moulure (40) et/ou une base de soupape (38) de soupape d'admission et/ou d'échappement (24, 26), un injecteur de carburant (42), une surface intérieure (44) d'un collecteur d'échappement et/ou tuyau d'échappement, une soupape de recyclage des gaz d'échappement, un radiateur de recyclage des gaz d'échappement et/ou une surface intérieure d'un turbocompresseur, en particulier de son compresseur.

14. Procédé pour la fabrication d'un revêtement d'une surface entrant en contact avec un mélange air-carburant ou un flux de gaz d'échappement d'au moins un composant d'une chambre de combustion et/ou d'un composant guidant les gaz d'échappement à proximité de la chambre de combustion d'un moteur à combustion interne selon une des revendications 1 à 13 **caractérisé en ce que** le revêtement a lieu par pulvérisation cathodique magnétron ou par pulvérisation par flux gazeux, pour lequel pendant la pulvérisation cathodique magnétron ou la pulvérisation par flux gazeux il s'établit une pression de service de l'ordre de 0,01 à 100 mbar et **en ce qu'**une précontrainte de substrat négative est appliquée au composant.

15. Procédé selon la revendication 14 **caractérisé en ce qu'**une pression de service de l'ordre de 0,05 à 10 mbars, de préférence de 0,1 à 1 mbar, est établie pendant la pulvérisation cathodique magnétron ou la pulvérisation par flux gazeux.

16. Procédé selon la revendication 14 ou 15 **caractérisé en ce qu'**au moins un métal de transition et/ou métal précieux actif du point de vue catalytique et au moins un oxyde métallique porteur sont déposés par pulvérisation Co parallèle ou consécutivement, de façon successive.
